# EUROPÄISCHE PATENTSCHRIFT

(11) **EP 1 676 470 B1**
(45) Veröffentlichungstag und Bekanntmachung des Hinweises auf die Patenterteilung: **02.05.2007**
(21) Anmeldenummer: 04790524.5
(22) Anmeldetag: 16.10.2004
(51) Int. Cl.: H05K 1/00, H05K 1/18

(54) **ELEKTRONISCHES BAUTEIL, BEISPIELSWEISE POSITIONSSENSOR**
ELECTRONIC COMPONENT, FOR EXAMPLE POSITION SENSOR
COMPOSANT ELECTRONIQUE, PAR EXEMPLE CAPTEUR DE POSITION

(30) Priorität: 22.10.2003 DE 10348980
(43) Veröffentlichungstag der Anmeldung: 05.07.2006
(73) Patentinhaber: Festo AG & Co., 73734 Esslingen (DE)
(72) Erfinder: SCHAUZ, Stephan, 73312 Geislingen/Steige (DE); SCHÜTTE, Manfred, 73779 Deizisau (DE)
(74) Vertreter: Abel, Martin
(86) Internationale Anmeldenummer: PCT/EP2004/011685
(87) Internationale Veröffentlichungsnummer: WO 2005/041625

(56) Entgegenhaltungen:
- DE-A1- 3 420 920
- DE-A1- 19 908 574
- DE-U1- 20 309 009
- US-A- 5 331 512
- US-A- 5 610 799

## Beschreibung

Die Erfindung betrifft ein elektronisches Bauteil, beispielsweise einen Positionssensor, mit einem Gehäuse, das mindestens eine Außenwand besitzt, die als in MID-Technologie (MID = Moulded Interconnect Device) ausgeführte MID-Außenwand ausgebildet ist, die an ihrer Innenfläche mit Kontaktflächen definierenden Leiterbahnen versehen ist.

Bei einem aus der DE 34 20 920 A1 bekannten, als Annäherungsschalter ausgebildeten elektronischen Bauteil ist ein bevorzugt aus Metall bestehendes röhrenförmiges Gehäuse vorgesehen, das einenends eine schlitzartige Durchbrechung aufweist, in die von innen her eine Leuchtdiode hineinragt, die auf einer Leiterplatte montiert und mit deren Leiterbahnen elektrisch kontaktiert ist. Die Herstellung und der Zusammenbau ist hier relativ aufwändig. Zur gehäusefesten Fixierung der Leuchtdiode muss ein zusätzliches Halteteil in die geschlitzte Durchbrechung eingesteckt werden.

Aus der DE 20309009 U1 geht ein insbesondere als Positionssensor konzipiertes elektrisches Bauteil der eingangs genannten Art hervor, das mit einem als MID-Bauteil ausgeführten Schaltungsträger ausgestattet ist, der an seiner Innenseite mit einem Sensorelement bestückt ist. Eine Leuchtdiode weist dieses elektrische Bauteil allerdings nicht auf.

In der DE 199 08 574 A1 wurde daher bereits ein elektronisches Bauteil vorgeschlagen, bei dem eine Leuchtdiode unter Einsatz der sogenannten MID-Technologie (MID = Moulded Interconnect Device) in einem Gehäuse installiert ist. Das Gehäuse ist längsgeteilt, wobei eine der Gehäusehälften an der Innenseite eine durch Heißprägen in MID-Technologie hergestellte Leiteranordnung trägt, die mit einer bedrahteten Leuchtdiode kontaktiert ist, welche in einer zwischen den beiden Gehäusewänden definierten Ausnehmung sitzt.

Bei den in den vorstehend abgehandelten Druckschriften beschriebenen Leuchtdioden könnte es sich beispielsweise um eine Bauart handeln, wie sie in der DE 102 05 698 A1 beschrieben wird. Die Leuchtdiode hat zwei drahtartige Kontaktelemente, die im Falle der DE 199 08 574 A1 so gebogen werden, dass sie auf Kontaktflächen der MID-Leiterbahnen aufliegen und mit diesen verlötet werden können. Auch das aus der DE 199 08 574 A1 bekannte elektronische Bauteil ist noch relativ aufwändig in der Herstellung und erfordert zur Installation der Leuchtdiode (LED) relativ viel Platz und diffizile Montageschritte.

Zur Realisierung kompakter Abmessungen sind als solches auch schon sogenannte SMD-Leuchtdioden bekannt geworden (SMD = Surface Mounted Device), die so ausgebildet sind, dass sie unmittelbar auf der Vorderseite (Surface) einer Trägerplatine verlötet werden können, im Gegensatz zu solchen Bauarten, bei denen die Kontaktdrähte durch die Trägerplatine hindurch gesteckt und an der Rückseite der Platine verlötet werden. Würde man im Falle der DE 34 20 920 A1 an Stelle der dort vorgesehenen, offensichtlich an der Rückseite der sie tragenden Leiterplatte verlöteten Leuchtdiode eine SMD-Leuchtdiode einsetzen, könnten die in der Höhenrichtung der Leuchtdiode gemessenen Querabmessungen des Bauteils allerdings kaum nennenswert verringert werden. Eine Verwendung bei dem Bauteil gemäß DE 199 08 574 A1, das auf MID-Technologie setzt, scheitert schon daran, dass biegbare Kontaktdrähte erforderlich sind, um die Leuchtdiode mit den in einer anderen Ebene verlaufenden Leiterbahnen zu kontaktieren.

Aus der US-A-5 331 512 ist eine SMD-Leuchtdiode bekannt, die in Upside-Down-Ausrichtung so an der Rückseite einer Leiterplatte installiert ist, dass sie in eine Durchbrechung der Leiterplatte hineinragt.

Aus der US 2001/0035573 A1 geht eine nach Art einer Leiterplatte konzipierte Montageplattform hervor, die auf einer Seite mit Leiterbahnen versehen ist und die über mindestens eine Durchbrechung verfügt, in die eine an der Seite der Leiterbahnen befestigte SMD-Leuchtdiode hineinragt. Die Montageplattform ist allerdings nicht als MID-Komponente ausgeführt. Auch beinhaltet die SMD-Leuchtdiode keinen als Gehäuse für den LED-Chip fungierenden lichtdurchlässigen Diodenkopf, sondern der das Licht emittierende LED-Chip ragt unumhüllt in die zugehörige Durchbrechung hinein, die bei Bedarf nachträglich noch mit einer Kunststoffmasse ausgefüllt werden kann.

Es ist die Aufgabe der vorliegenden Erfindung, ein mit mindestens einer Leuchtdiode ausgestattetes elektronisches Bauteil zu schaffen, das bei kompakten Abmessungen relativ einfach herstellbar ist.

Zur Lösung dieser Aufgabe ist bei einem elektronischen Bauteil der eingangs genannten Art vorgesehen, dass die MID-Außenwand an mindestens einer Stelle eine Durchbrechung aufweist, in die vom Gehäuseinnenraum her eine Leuchtdiode hineinragt, die mit im Gehäuseinnenraum neben der Durchbrechung liegenden Kontakflächen der Leiterbahnen elektrisch kontaktiert ist, und dass die Leuchtdiode als SMD-Leuchtdiode (SMD = Surface Mounted Device) ausgeführt ist, die einen LED-Chip und einen diesen abdeckenden lichtdurchlässigen Diodenkopf aufweist und die in Upside-Down-Ausrichtung so an der Innenfläche der MID-Außenwand angeordnet ist, dass ihr lichtdurchlässiger Diodenkopf in die umfangsseitig ringsum geschlossene Durchbrechung hineinragt und ihr diesbezüglich breiterer Diodensockel an den Kontaktflächen anliegt und mit diesen elektrisch kontaktiert ist, wobei der Diodensockel in eine an der Innenfläche der MID-Außenwand vorgesehene Vertiefung eintaucht, deren Breite im Wesentlichen derjenigen des Diodensockels entspricht.

Da die zur Kontaktierung der Leuchtdiode vorgesehenen Leiterbahnen unmittelbar an der Innenfläche der Außenwand des Gehäuses vorgesehen sind, was durch den Einsatz der MID-Technologie möglich ist, kann auf den Einsatz einer gesonderten, viel Platz beanspruchenden Platine verzichtet werden. Die Handhabung beim Zusammenbau des elektronischen Bauteils wird durch Verwendung einer SMD-Leuchtdiode stark vereinfacht, weil keine langen, filigranen Kontaktdrähte gebogen und kontaktiert werden müssen. Da die die Durchbrechung aufweisende MID-Außenwand unmittelbar an ihrer Innenfläche mit den Kontaktflächen für die Leuchtdiode ausgestattet ist, ist eine direkte Bestückung und Kontaktierung ohne überbrückende Kontaktierungsdrähte möglich. Indem der Diodenkopf in die ringsum geschlossene Durchbrechung hineinragt, gelangt die Lichtquelle sehr nahe zur Außenseite des Gehäuses und ist gut sichtbar. Darüber hinaus lässt sich bei Bedarf der zwischen dem Diodenkopf und der diesen umgebenden Durchbrechungswand liegende Bereich mit geringem Aufwand zuverlässig abdichten. Insgesamt ermöglicht die Erfindung eine direkte LED-Integration kompakter SMD-Leuchtdioden.

Vor allem einer vereinfachten Montage kommt es zugute, dass die MID-Außenwand an der Innenfläche eine Vertiefung aufweist, deren Breite im Wesentlichen derjenigen des Diodensockels entspricht und in die der Diodensockel, zweckmäßigerweise formschlüssig, eintaucht.

Vorteilhafte Weiterbildungen der Erfindung gehen aus den Unteransprüchen hervor.

Zur Kontaktierung der SMD-Leuchtdiode ist deren Diodensockel mit den zugeordneten Kontaktflächen der Leiterbahnen zweckmäßigerweise verlötet.

Um die Leuchtdiode vor Beschädigung zu schützen, empfiehlt es sich, den Diodenkopf ohne Überstand bezüglich der Außenfläche der MID-Außenwand im Innern der Durchbrechung enden zu lassen. Vorzugsweise ist die Stirnfläche des Diodenkopfes gegenüber der Außenfläche der MID-Außenwand ein Stück weit zurückversetzt.

Prinzipiell wäre es möglich, das Gehäuse des elektronischen Bauteils so auszubilden, dass nur die mit der SMD-Leuchtdiode bestückte Außenwand als MID-Körper ausgebildet ist. Als besonders vorteilhaft wird es allerdings angesehen, das gesamte Gehäuse als MID-Komponente zu realisieren.

Beispielsweise kann das Gehäuse napf- oder trogartig ausgeführt werden, wobei es eine von der MID-Außenwand gebildete Basiswand und eine vom Rand der Basiswand wegragende umlaufende Seitenwand aufweist und wobei der von dem Gehäuse definierte Gehäuseinnenraum durch eine ausgehärtete Vergussmasse ausgefüllt ist, durch die die Leiterbahnen, die SMD-Leuchtdiode und eventuelle sonstige im Gehäuseinnenraum platzierte Elektronikkomponenten abgedeckt und dicht gekapselt werden.

Der Diodenkopf und die diesen unschließende Durchbrechungswand sind vorzugsweise so aufeinander abgestimmt, dass dazwischen ein nur sehr schmaler, kapillarer Ringspalt vorliegt, in dem sich ein das Eindringen von Verunreinigungen oder Flüssigkeit verhindernder Dichtwerkstoff befindet. Der Dichtwerkstoff ist zweckmäßigerweise ein Material, das im Verarbeitungszustand flüssige Konsistenz aufweist und nach der Verarbeitung von selbst oder durch Zufuhr externer Energie aushärtet. Auf Grund der Kapillarität des Ringspaltes wird der Dichtwerkstoff quasi selbsttätig in den Ringspalt hineingesaugt, wo er sich um den Leuchtdiodenkopf herum verteilt und auf diese Weise eine sehr zuverlässige Abdichtung bewirkt.

Als Dichtwerkstoff wird zweckmäßigerweise ein Klebstoff eingesetzt.

Das Applizieren des Dichtwerkstoffes wird dadurch begünstigt, dass im Bereich des Außenumfanges der Leuchtdiode zwischen dieser und der MID-Außenwand mindestens eine in den Ringspalt übergehende und bezüglich dem Ringspalt breitere Ausfüllaussparung vorgesehen ist, die zum Gehäuseinnenraum hin offen ist, um das Einfüllen flüssigen Dichtwerkstoffes zu ermöglichen. Der Dichtwerkstoff wird also lediglich in die Einfüllaufsparung eingebracht, von wo aus er auf Grund der Kapillarwirkung in den Ringspalt fließt und dort die gesamte Leuchtdiode umfließt. Durch die Sättigung des kapillaren Systems aus der Einfüllaussparung wird die Qualität des Dichtprozesses vom eingefüllten Volumen an Dichtwerkstoff nicht beeinträchtigt, so dass sich eine hohe Prozesssicherheit ergibt. Der flüssige Dichtwerkstoff wird über Oberflächenspannung an geeigneten Fangkanten gestoppt, wodurch sich ein gleichmäßiger Meniskus zwischen der MID-Außenwand und der Leuchtdiode einstellt.

Bei Bedarf können mehrere Einfüllaussparungen vorgesehen sein. Empfehlenswert sind zwei Einfüllaussparungen, die sich auf einander entgegengesetzten Seiten der Leuchtdiode befinden.

Nachfolgend wird die Erfindung anhand der beiliegenden Zeichnung näher erläutert. In dieser zeigen:
- Figur 1: eine mögliche Bauform des erfindungsgemäßen elektronischen Bauteils in einer Ausgestaltung als Positionssensor in einer perspektivischen Draufsicht,
- Figur 2: einen vergrößerten Ausschnitt des Bauteils der Figur 1 im Bereich seiner Leuchtdiode,
- Figur 3: den in Figur 2 gezeigten Ausschnitt in einer Unteransicht und gleichzeitig längs geschnitten, wobei die Schnittschraffuren nicht gezeigt sind,
- Figur 4: einen Längsschnitt durch das Bauteil gemäß Schnittlinie IV-IV aus Figur 2,
- Figur 5: einen Querschnitt durch das Bauteil gemäß Schnittlinie V-V aus Figur 2, und
- Figur 6: eine ausschnittsweise Unteransicht des elektronischen Bauteils im Längsschnitt und unter Weglassung der Vergussmasse.

Das Ausführungsbeispiel zeigt ein elektronisches Bauteil 1 in einer exemplarischen Ausgestaltung als Positionssensor. Alternativ lässt sich die Erfindung allerdings auch an beliebigen anderen elektronischen Bauteilen realisieren, beispielsweise bei elektronischen Steuergeräten, bei Anzeigetafeln, etc.. Obgleich sich die nachfolgende Beschreibung an dem abgebildeten Positionssensor orientiert, gelten die Ausführungen entsprechend auch für alle anderen möglichen Realisierungsformen des elektronischen Bauteils.

Das Bauteil 1 besitzt ein längliches, beim Ausführungsbeispiel etwa balkenähnlich gestaltetes Funktionsteil 2, an das ein Kabel 3 angeschlossen ist. Das Funktionsteil 2 hat eine Längsachse 4, eine dazu rechtwinkelige Querachse 5 und eine zu den vorgenannten Achsen rechtwinkelige Hochachse 6.

Der Positionssensor ist insbesondere zur Installation an einem durch Fluidkraft oder elektrisch betriebenen Linearantrieb vorgesehen, um eine vorbestimmte Position des Antriebsteils dieses Linearantriebes zu erfassen. Die Positionserfassung geschieht berührungslos und basiert auf dem Zusammenwirken eines an dem nicht gezeigten Antriebsteil angeordneten Betätigungselementes mit einem in dem Funktonsteil 2 angeordneten, lediglich strichpunktiert angedeuteten Sensorelement 7. Das Sensorelement 7 kann beispielsweise ein sogenannter Hall-Sensor sein.

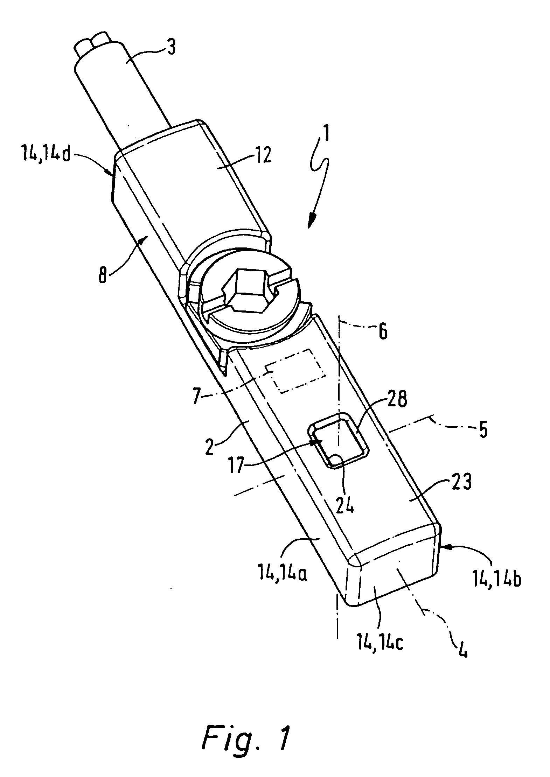

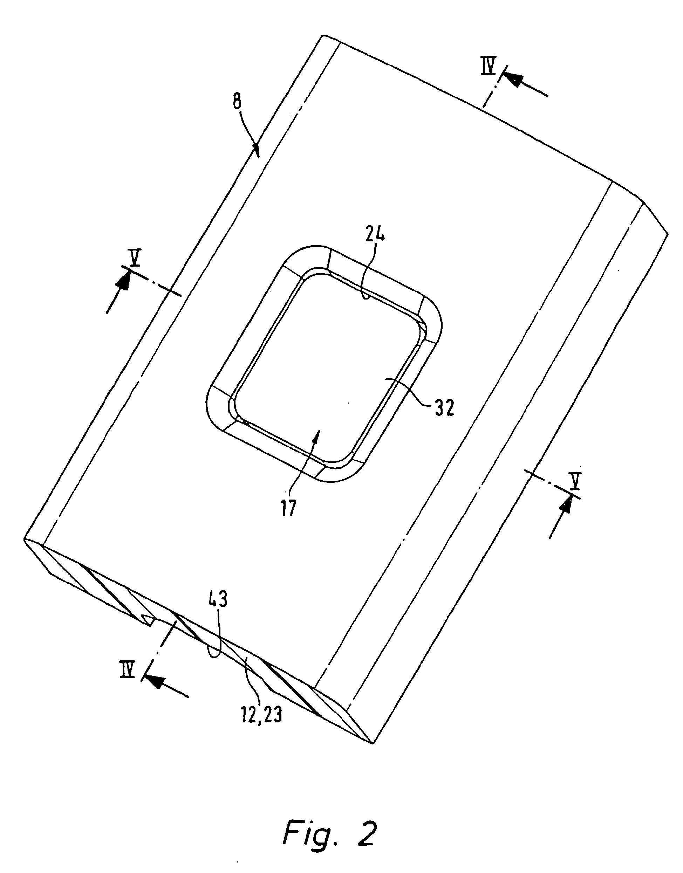

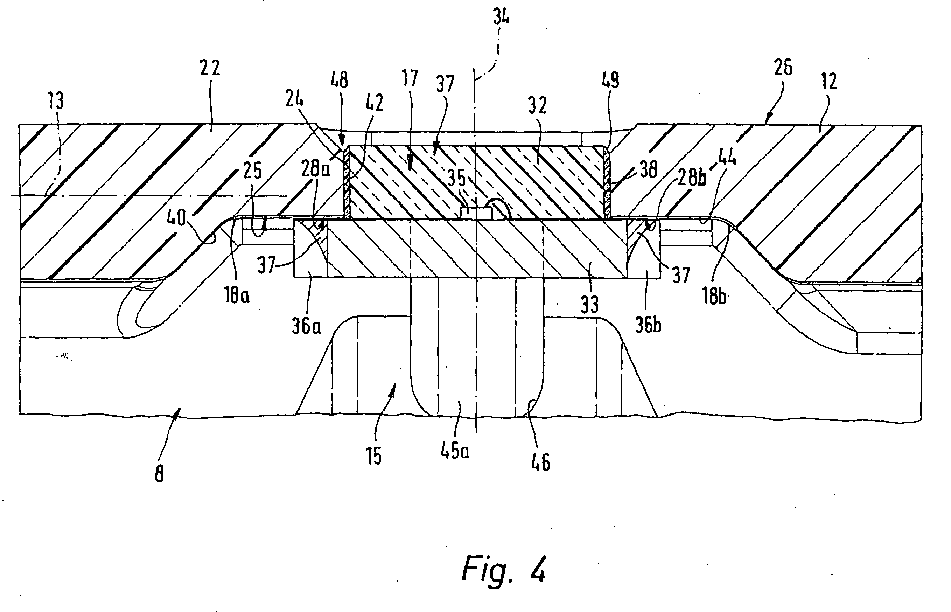

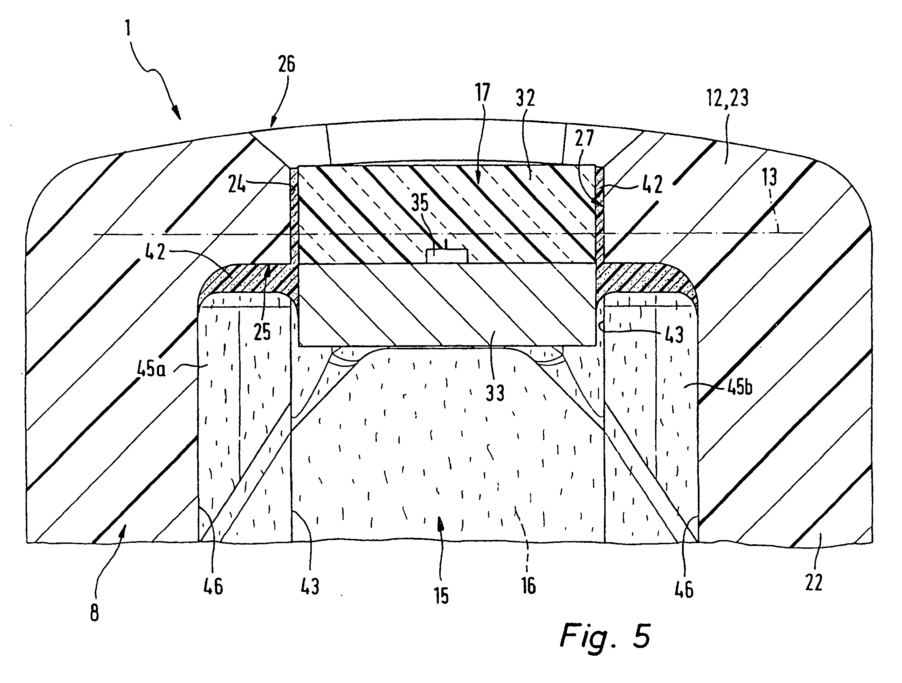

Das Funktionsteil 2 besitzt ein längliches Gehäuse 8, das insbesondere napf- oder trogartig ausgebildet ist. Es besitzt eine in Figuren 1 und 2 oben liegende Basiswand 12, die sich in einer durch die Längsachse 4 und die Querachse 5 aufgespannten Hauptebene 13 erstreckt (vgl. Fig. 4 und 5). Vom Rand der Basiswand 12 ragt ringsum eine Seitenwand 14 weg, und zwar insbesondere rechtwinkelig zu der Hauptebene 13. Da beim Ausführungsbeispiel die Basiswand 12 einen rechteckigen Umriss hat, präsentiert sich die Seitenwand 14 mit zwei zueinander parallelen längsseitigen Seitenwandabschnitten 14a, 14b und zwei stirnseitigen Seitenwandabschnitten 14c, 14d.

Mit seinen Wänden 12, 14 definiert das Gehäuse 8 einen Gehäuseinnenraum 15, der mit elektronischen Komponenten bestückt ist und der im Übrigen durch eine lediglich in Figur 5 schematisch angedeutete Vergussmasse 16 ausgegossen ist, die gleichzeitig den Verschluss des Gehäuseinnenraumes 15 an der der Basiswand 12 entgegengesetzten offenen Seite des Gehäuses 8 bildet. Die Vergussmasse 16 wird bei der Herstellung in flüssigem oder pastösem Zustand eingebracht und anschließend ausgehärtet.

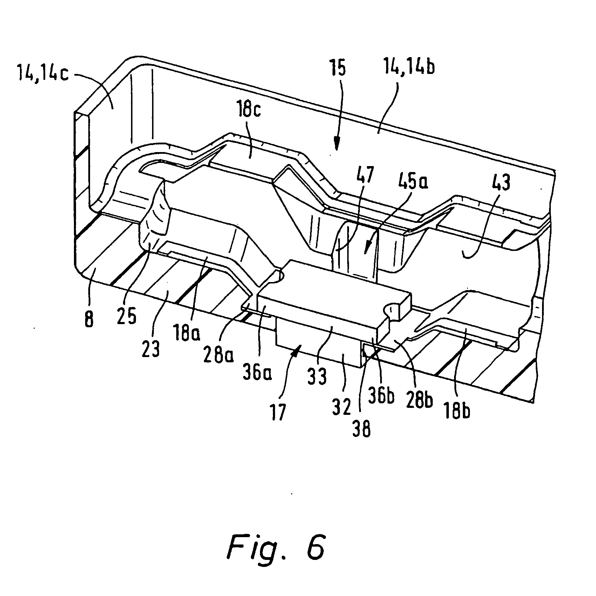

Durch die Vergussmasse 16 erfolgt eine fluiddichte Kapselung der schon erwähnten Elektronikkomponenten, unter denen sich beim Ausführungsbeispiel das Sensorelement 7 sowie eine Leuchtdiode 17 befinden. Diese Elektronikkomponenten gehören zu einer im Gehäuseinnenraum 15 untergebrachten elektrischen Schaltung, zu der bei Bedarf noch weitere, nicht dargestellte Elektronikkomponenten gehören und die mehrere Leiterbahnen beinhaltet, von denen in der Zeichnung mit Ausnahme von Figur 6 jedoch lediglich zwei Stück (18a, 18b) abgebildet sind.

Das Gehäuse 8 ist insgesamt als MID-Komponente ausgebildet (MID = Moulded Interconnect Device), wobei die Basiswand 12 und die Seitenwand 14 Bestandteil eines einstückigen, aus spritzgegossenem Kunststoffmaterial bestehenden Trägerelementes 22 sind. Es fungiert als Träger für die erwähnte Schaltung, also für die Leiterbahnen und die mit diesen kontaktierten Elektronikkomponenten. Die Leiterbahnen 18a, 18b sind an der Innenfläche der Basiswand 12 und bei Bedarf auch an der Innenfläche der Seitenwand 14 angeordnet, wo sie bei der Fertigung des Gehäuses 8 durch Metallisierung des Trägerelements 22 strukturiert wurden.

Für die Erfindung ist relevant, dass das elektronische Bauteil mindestens eine Außenwand besitzt, die an mindestens einer Stelle eine Durchbrechung aufweist, in die vom Gehäuseinnenraum her eine Leuchtdiode hineinragt, die mit innen am Gehäuse vorgesehenen Leiterbahnen elektrisch kontaktiert ist. Ferner ist wichtig, dass zumindest die die Durchbrechung aufweisende Außenwand in MID-Technologie ausgeführt ist, wobei besagte Außenwand im Folgenden als MID-Außenwand 23 bezeichnet sei. Diese MID-Außenwand 23 ist beim Ausführungsbeispiel von der Basiswand 12 gebildet.

Wie schon erwähnt, ist es zugunsten einer kostengünstigen Fertigung des elektronischen Bauteils 1 zweckmäßig, nicht nur einen Teil der Gehäusewand, sondern die gesamte Gehäusewand in MID-Technologie auszuführen und die dem Gehäuseinnenraum 15 zugewandten Innenflächen als Tragflächen für Leiterbahnen heranzuziehen, die zur Realisierung der in dem Bauteil integrierten elektronischen Schaltung notwendig sind.

Beim Ausführungsbeispiel ist die von der Basiswand 12 gebildete MID-Außenwand 23 mit der schon angesprochenen Durchbrechung 24 versehen, welche die MID-Außenwand 23 von ihrer dem Gehäuseinnenraum 15 zugewandten Innenfläche 25 bis zu der an der Umgebung liegenden Außenfläche 26 nach Art eines Loches durchsetzt und die umfangsseitig ringsum geschlossen ist. Begrenzt wird die Durchbrechung 24 dabei von einer umlaufenden Wand, die als Durchbrechungswand 27 bezeichnet sei.

Die beiden in der Zeichnung gezeigten Leiterbahnen 18a, 18b dienen der elektrischen Kontaktierung der Leuchtdiode 17. Sie verlaufen auf der Innenfläche 25, wobei sie bis unmittelbar an die Durchbrechung 24 herangeführt sind und neben der Durchbrechung liegende Kontaktflächen 28a, 28b definieren. Diese Kontaktflächen 28a, 28b stehen über die Leiterbahnen 18a, 18b mit einer oder mehreren nicht näher gezeigten Elektronikkomponenten der in dem elektronischen Bauteil 1 integrierten elektrischen Schaltung in Verbindung. Die Verbindung ist insbesondere so ausgeführt, dass die Leuchtdiode 17 den Schaltzustand des Sensorelements 7 optisch wiedergeben kann und beispielsweise dann Licht aussendet, wenn das Sensorelement 7 anspricht.

Die Leuchtdiode 17 ist als sogenannte SMD-Leuchtdiode (SMD = Surface Mounted Device) ausgeführt, die über einen lichtdurchlässigen, insbesondere aus Kunststoffmaterial bestehenden Diodenkopf 32 verfügt, der in Richtung der Diodenhochachse 34 auf einem Diodensockel 33 sitzt, der in wenigstens einer Richtung quer zur Diodenhochachse 34 über eine größere Breite verfügt als der Diodenkopf 32. An dem Diodensockel 33 ist ein LED-Chip 35 platziert, der durch den transluzenten Diodenkopf 32 abgedeckt ist. Der LED-Chip 35 sitzt also an der dem Diodenkopf 32 zugewandten Seite des Diodensockels 33. Er ist in der Lage, bei Anliegen einer Spannung Licht zu emittieren, das durch den Diodenkopf 32 hindurch nach außen tritt und somit sichtbar wird. Der Diodenkopf 32 kann hierbei als Linse fungieren. An dem Diodensockel 33 sind zwei Kontaktpads 36a, 36b vorgesehen, die in elektrisch voneinander isolierter Weise mit dem LED-Chip 35 kontaktiert sind. Sie sitzen beim Ausführungsbeispiel an zwei einander entgegengesetzten Endbereichen des Diodensockels 33.

Die SMD-Leuchtdiode 17 ist Upside-Down, also mit dem Diodenkopf 32 voraus, vom Gehäuseinnenraum 15 her so eingesetzt, dass der Diodenkopf 32 von innen her in die Durchbrechung 24 eintaucht und der diesbezüglich breitere Diodensockel 33 mit seinen Kontaktpads 36a, 36b an den neben der Durchbrechung an der Innenfläche 25 der MID-Außenwand 23 vorgesehenen Kontaktflächen 28a, 28b zur Anlage gelangt. Die Diodenhochachse 34 ist dann parallel zur Hochachse 6 des Gehäuses 8 ausgerichtet. Die Einstecktiefe wird durch den im Umfangsbereich der Durchbrechung 24 an der MID-Außenwand 23 zur Anlage gelangenden Diodensockel 33 definiert.

Zum Erhalt der gewünschten elektrischen Verbindung ist Lot 37 im Übergangsbereich zwischen einem jeweiligen Kontaktpad 36a, 36b und der zugeordneten Kontaktfläche 28a, 28b appliziert. Alternativ ist aber auch jede andere elektrisch leitende Verbindung möglich, beispielsweise unter Verwendung eines Leitklebers.

Beim Ausführungsbeispiel hat der den LED-Chip 35 umschließende Diodenkopf 32 einen quadratischen Umriss. Der Diodensockel 33 hingegen ist rechteckig konturiert mit einer Breite, die derjenigen des Diodenkopfes 32 entspricht und mit einer Länge, die größer ist als diejenige des Diodenkopfes 32, so dass er an entgegengesetzten Seiten rechtwinkelig zur Diodenhochachse 34 mit Endabschnitten über den Diodenkopf 32 hinausragt, die die Kontaktpads 36a, 36b bilden oder mit diesen versehen sind.

Um eine Beschädigung der Leuchtdiode 17 durch externe mechanische Einflüsse zu verhindern, ist beim Ausführungsbeispiel vorgesehen, dass der Diodenkopf 32 ohne Überstand bezüglich der zur Durchbrechung 24 benachbarten Außenfläche 26 der MID-Außenwand 23 angeordnet ist und folglich noch im Innern der Durchbrechung 24 endet. Bevorzugt ist die vom Diodensockel 33 in Höhenrichtung wegweisende Stirnfläche 37 des Diodenkopfes 32 ein Stück weit gegenüber der Außenfläche 26 zurückversetzt, wie dies aus Figuren 4 und 5 gut ersichtlich ist. Die Stirnfläche 37 bildet die Lichtaustrittsfläche für das vom LED-Chip 35 erzeugte Licht, wobei eine sich ausgehend von der Stirnfläche 37 zur Außenfläche 26 hin im Querschnitt vergrößernde Durchbrechung trotz der versenkten Anordnung des Diodenkopfes 32 eine breite Lichtstreuung garantiert.

Aus dem Geschilderten und aus den Zeichnungen ist ersichtlich, dass sich die durch die MID-Herstellung realisierten Kontaktflächen 28a, 28b für die Leuchtdiode 17 unmittelbar innen an derjenigen Außenwand (MID-Außenwand 23) befinden, die auch die den Diodenkopf 32 aufnehmende Durchbrechung 24 enthält. Die mit den Kontaktflächen 28a, 28b versehene Innenfläche 25 der MID-Außenwand 23 verläuft rechtwinkelig zur Diodenhochachse 34, so dass bei der in Richtung der Diodenhochachse 34 erfolgenden Einsteckmontage der Leuchtdiode 17 automatisch gewährleistet ist, dass die Kontaktpads 36a, 36b auf die in der Montagerichtung gegenüberliegenden Kontaktflächen 28a, 28b treffen. Die Kontaktflächen erstrecken sich insbesondere in einer zu der Hauptebene 13 parallelen Ebene. Ein umständliches Biegen von Kontaktierungsdrähten erübrigt sich somit und es ist insbesondere nicht erforderlich, Maßnahmen vorzusehen, durch die die Leuchtdiode 17 mit Kontaktflächen an der rechtwinkelig orientierten Seitenwand 14 zu kontaktieren wäre.

Die Durchbrechung 24 hat einen zum Diodenkopf 32 komplementären Umriss. Somit verbleibt zwischen dem Diodenkopf 32 und der diesen umgebenden Durchbrechungswand 24 ein minimaler, kapillarer Ringspalt 38. Dieser ist mit einem Dichtwerkstoff 42 gefüllt, so dass durch ihn hindurch keinerlei Fremdkörper hindurchdringen können. Die im Gehäuseinnenraum 15 befindliche elektronische Schaltung und deren Komponenten sind mithin insbesondere vor Feuchtigkeit geschützt und es kann auch eine zuverlässige Abschirmung vor elektromagnetischen Wellen erreicht werden.

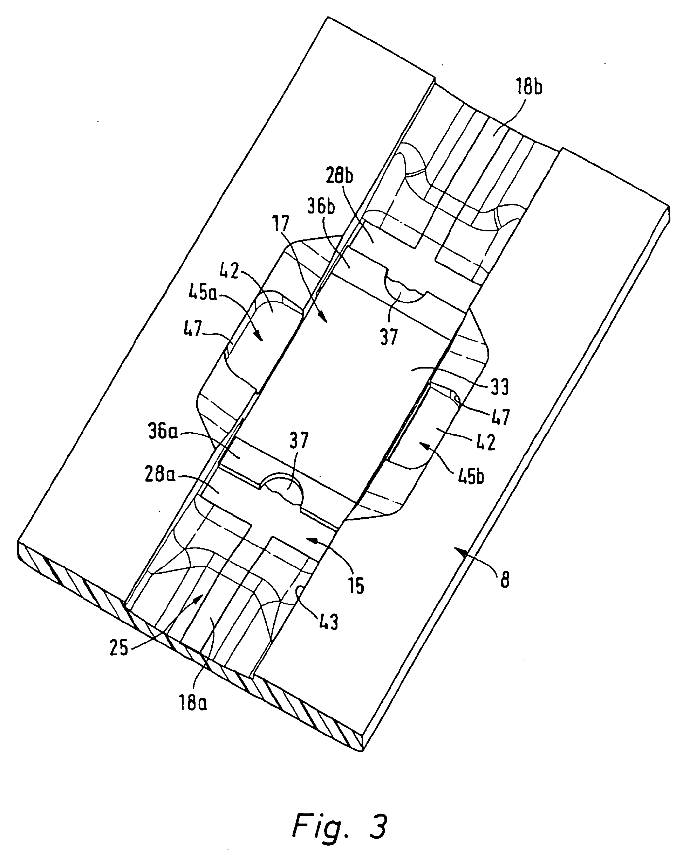

Beim Ausführungsbeispiel ist die MID-Außenwand 23 an ihrer Innenfläche 25 mit einer in Richtung der Längsachse 4 verlaufenden Vertiefung 43 versehen, deren Breite im Wesentlichen derjenigen des Diodensockels 33 entspricht, wobei dieser in die Vertiefung insbesondere formschlüssig eintaucht. Vor allem aus Figuren 3 und 5 ist diese Anordnung gut ersichtlich.

Die Kontaktflächen 28a, 28b finden sich an der Grundfläche 44 der Vertiefung 43. Diese Grundfläche verläuft beim Ausführungsbeispiel so, dass sie über in Höhenrichtung 6 auf unterschiedlichem Höhenniveau liegende Grundflächenabschnitte besitzt. Solche Grundflächenabschnitte können über rampenförmige Flächenabschnitte 40 ineinander übergehen, entlang denen sich die Leiterbahnen 18a, 18b erstrecken.

Um den Dichtwerkstoff 42 einfach und zuverlässig in den Ringspalt 38 einbringen zu können, sind im Bereich des Außenumfanges der Leuchtdiode 17 zwischen dieser und der MID-Außenwand 23 zwei in den Ringspalt 38 übergehende Einfüllaussparungen 45a, 45b vorgesehen, die mit einer Zuführöffnung 46 zum Gehäuseinnenraum 15 hin offen sind und die quer zur Hochachse 6 wesentlich breiter sind als der Ringspalt 38. Beim Ausführungsbeispiel befinden sich die beiden Einfüllaussparungen 45 in Richtung der Querachse 5 auf einander entgegengesetzten Seiten der Leuchtdiode 17, im Bereich der längsseitigen Flanken der Vertiefung 43.

Definiert werden die Einfüllaussparungen 45 von jeweils einer in der MID-Außenwand 23 vorgesehenen Materialausnehmung 47, die rinnenartig in Höhenrichtung des Gehäuses 8 verläuft, wobei ihre längsseitige Öffnung der Leuchtdiode 17 zugewandt ist, von der sie entlang eines Teils ihrer Länge abgedeckt wird.

Die Einfüllaussparungen 45 erstrecken sich in Höhenrichtung bis zu der Grundfläche 44, so dass die an der offenen Seite vom Diodensockel 33 flankiert wird.

Anstelle zweier Einfüllaussparungen kann auch nur eine Einfüllaussparung vorgesehen sein, insbesondere wenn die Durchbrechung 24 einen relativ kleinen Querschnitt aufweist. Darüber hinaus können auch mehr als zwei Einfüllaussparungen vorgesehen werden, insbesondere wenn die Durchbrechung 24 über einen relativ großen Querschnitt verfügt.

Beim Zusammenbau des elektronischen Bauteils 1 wird flüssiger Dichtwerkstoff, bei dem es sich vorzugsweise um einen Klebstoff handelt, in die Einfüllaussparungen 45 eingefüllt. Von dort gelangt der Dichtwerkstoff auf Grund der Kapillarwirkung in den Ringspalt 38, in dem er sich verteilt, so dass er den Ringspalt 38 vollständig ausfüllt. Durch geeignete Fangkanten 48, insbesondere gebildet vom Übergangsbereich zwischen dem Abschnitt konstanten Querschnittes und dem Abschnitt sich nach außen hin erweiternden Querschnittes der Durchbrechung 24, wird die Flüssigkeit gestoppt, so dass sich ein gleichmäßiger Meniskus 49 zwischen der MID-Außenwand 23 und dem Diodenkopf 32 einstellt.

Anschließend härtet der Dichtwerkstoff aus, entweder von selbst oder durch Energieeintrag von außen, in Abhängigkeit von der Art des Dichtwerkstoffes.

Aus der Figur 6 gehen weitere Details einer in dem Gehäuseinnenraum 15 untergebrachten elektrischen Schaltung hervor, wobei eine weitere Leiterbahn 18c ersichtlich ist, die sich wie die schon erläuterten Leiterbahnen 18a, 18b auf der Innenfläche 25 der MID-Außenwand 23 erstreckt, jedoch auf einem anderen Höhenniveau platziert ist. Aus Figur 6 ist auch nochmals gut ersichtlich, dass zumindest diejenige Außenwand, in der die Durchbrechung 24 für den Diodenkopf 32 angeordnet ist, als MID-Außenwand 23 ausgebildet ist, wobei an der Innenfläche 25 dieser MID-Außenwand 23 die Kontaktflächen 28a, 28b vorgesehen sind, mit denen der Diodensockel 33 elektrisch kontaktiert ist. Das für die Lötverbindung zwischen den Kontaktpads 36a, 36b und den Kontaktflächen 28a, 28b verwendete Lot ist in Figur 6 der Übersichtlichkeit wegen nicht dargestellt, ebenso wenig wie die zweckmäßigerweise in den Gehäuseinnenraum 15 eingebrachte Vergussmasse, die als dichter Verschluss für das Gehäuse 8 fungiert.

## Patentansprüche

1. Elektronisches Bauteil, beispielsweise Positionssensor, mit einem Gehäuse (8), das mindestens eine Außenwand besitzt, die als in MID-Technologie (MID = Moulded Interconnect Device) ausgeführte MID-Außenwand (23) ausgebildet ist, die an ihrer Innenfläche (25) mit Kontaktflächen (28a, 28b) definierenden Leiterbahnen (18a, 18b) versehen ist, **dadurch gekennzeichnet, dass** die MID-Außenwand (23) an mindestens einer Stelle eine Durchbrechung (24) aufweist, in die vom Gehäuseinnenraum (15) her eine Leuchtdiode (17) hineinragt, die mit im Gehäuseinnenraum (15) neben der Durchbrechung (24) liegenden Kontakflächen (28a, 28b) der Leiterbahnen (18a, 18b) elektrisch kontaktiert ist, und dass die Leuchtdiode (17) als SMD-Leuchtdiode (SMD = Surface Mounted Device) ausgeführt ist, die einen LED-Chip (35) und einen diesen abdeckenden lichtdurchlässigen Diodenkopf (32) aufweist und die in Upside-Down-Ausrichtung so an der Innenfläche (25) der MID-Außenwand (23) angeordnet ist, dass ihr lichtdurchlässiger Diodenkopf (32) in die umfangsseitig ringsum geschlossene Durchbrechung (24) hineinragt und ihr diesbezüglich breiterer Diodensockel (33) an den Kontaktflächen (28a, 28b) anliegt und mit diesen elektrisch kontaktiert ist, wobei der Diodensockel (33) in eine an der Innenfläche (25) der MID-Außenwand (23) vorgesehene Vertiefung (43) eintaucht, deren Breite im Wesentlichen derjenigen des Diodensockels (33) entspricht.

2. Bauteil nach Anspruch 1, **dadurch gekennzeichnet, dass** der Diodensockel (33) mit den zugeordneten Kontaktflächen (28a, 28b) zur Kontaktierung verlötet ist.

3. Bauteil nach Anspruch 1 oder 2, **dadurch gekennzeichnet, dass** der Diodenkopf (32) ohne Überstand bezüglich der Außenfläche (26) der MID-Außenwand (23) im Innern der Durchbrechung (24) endet.

4. Bauteil nach einem der Ansprüche 1 bis 3, **dadurch gekennzeichnet, dass** das Gehäuse (8) insgesamt eine MID-Komponente ist.

5. Bauteil nach einem der Ansprüche 1 bis 4, **dadurch gekennzeichnet, dass** das Gehäuse (8) napf- oder trogartig mit einer von der MID-Außenwand (23) gebildeten Basiswand (12) und einer vom Rand der Basiswand (12) wegragenden umlaufenden Seitenwand (14) ausgebildet ist, wobei der von dem Gehäuse (8) definierte Gehäuseinnenraum (15) durch eine ausgehärtete Vergussmasse (16) ausgefüllt ist.

6. Bauteil nach einem der Ansprüche 1 bis 5, **dadurch gekennzeichnet, dass** zwischen dem Diodenkopf (32) und der diesen umgebenden Durchbrechungswand (27) ein mit Dichtwerkstoff (42) gefüllter Ringspalt (38) vorgesehen ist.

7. Bauteil nach Anspruch 6, **dadurch gekennzeichnet, dass** es sich bei dem Ringspalt (38) um einen kapillaren Ringspalt handelt.

8. Bauteil nach Anspruch 6 oder 7, **dadurch gekennzeichnet, dass** der Dichtwerkstoff (42) ein im Verarbeitungszustand flüssige Konsistenz aufweisender, später aushärtender Werkstoff ist.

9. Bauteil nach einem der Ansprüche 6 bis 8, **dadurch gekennzeichnet, dass** der Dichtwerkstoff (42) ein Klebstoff ist.

10. Bauteil nach einem der Ansprüche 6 bis 9, **dadurch gekennzeichnet, dass** im Bereich des Außenumfanges der Leuchtdiode (17) zwischen dieser und der MID-Außenwand (23) mindestens eine in den Ringspalt (38) übergehende und bezüglich dem Ringspalt (23) breitere Einfüllaussparung (45) vorgesehen ist, die zum Gehäuseinnenraum (15) hin offen ist für das Einfüllen flüssigen Dichtwerkstoffes (42) beim Zusammenbau des Bauteils.

11. Bauteil nach Anspruch 10, **gekennzeichnet durch** zwei Einfüllaussparungen (45) auf einander entgegengesetzten Seiten der Leuchtdiode (17).

12. Bauteil nach Anspruch 10 oder 11, **dadurch gekennzeichnet, dass** die Einfüllaussparung (45) von einer seitlich zumindest partiell von der Leuchtdiode (17) überdeckten Materialausnehmung (47) der MID-Außenwand (23) gebildet ist.

## Claims

1. Electronic component, for example position sensor, with a housing (8) having at least one external wall designed as MID external wall (23) in MID technology (MID = Moulded Interconnect Device) provided with conductors (18a, 18b) defining contact surfaces (28a, 28b) on its inner surface (25), **characterised in that** the MID external wall (23) has an opening (24) in at least one location, into which a light-emitting diode (17) which is in electric contact with contact surfaces (28a, 28b) of the conductors (18a, 18b) located in the housing interior (15) adjacent to the opening (24) projects from the housing interior (15), and **in that** the light-emitting diode (17) is designed as an SMD light-emitting diode (SMD = Surface Mounted Device) with a LED chip (35) and a transparent diode head (32) covering the former, which is arranged in upside-down orientation on the inner surface (25) of the MID external wall (23) such that the transparent diode head (32) projects into the circumferentially enclosed opening (24), its wider diode base (33) bearing against the contact surfaces (28a, 28b) and being electrically bonded thereto, wherein the diode base (33) dips into a recess (43) provided in the inner surface (25) of the MID external wall (23), the width of which is substantially equal to that of the diode base (33).

2. Component according to claim 1, **characterised in that** the diode base (33) is soldered to the associated contact surfaces (28a, 28b) for bonding.

3. Component according to claim 1 or 2, **characterised in that** the diode head (32) terminates within the opening (24) without projecting from the outer surface (26) of the MID external wall (23).

4. Component according to any of claims 1 to 3, **characterised in that** the housing (8) in total is a MID component.

5. Component according to any of claims 1 to 4, **characterised in that** the housing (8) is designed bowl- or trough-shaped with a base wall (12) represented by the MID external wall (23) and a continuous side wall (14) extending from the edge of the base wall (12), wherein the housing interior (15) defined by the housing (8) is filled with a cured potting compound (16).

6. Component according to any of claims 1 to 5, **characterised in that** an annular gap (38) filled with a sealing material (42) is provided between the diode head (32) and the surrounding wall (27) of the opening.

7. Component according to claim 6, **characterised in that** the annular gap (38) is a capillary gap.

8. Component according to claim 6 or 7, **characterised in that** the sealing material (42) is a material of liquid consistency in the processing state, which is then cured.

9. Component according to any of claims 6 to 8, **characterised in that** the sealing material (42) is an adhesive.

10. Component according to any of claims 6 to 9, **characterised in that**, in the region of the outer circumference of the light-emitting diode (17), between said diode and the MID external wall (23), there is provided at least one filling recess (45) merging into the annular gap (23) and wider than the annular gap (23), which is open towards the housing interior (15) and used for pouring in liquid sealing material (42) during the assembly of the component.

11. Component according to claim 10, **characterised by** two filling recesses (45) on opposite sides of the light-emitting diode (17).

12. Component according to claim 10 or 11, **characterised in that** the filling recess (45) is represented by a material recess (47) in the MID external wall (23), which is at least partially covered laterally by the light-emitting diode (17).

## Revendications

1. Composant électronique, par exemple détecteur de position, avec un boîtier (8), qui comporte au moins une paroi extérieure qui est conçue comme une paroi extérieure MID (23) réalisée selon la technologie MID (MID = Moulded Interconnect Device), laquelle est munie sur sa face intérieure (25) de surfaces de contact (28a, 28b) définissant des pistes conductrices (18a, 18b), **caractérisé en ce que** la paroi extérieure MID (23) comporte un percement (24) à au moins un endroit dans lequel une diode électroluminescente (17) fait saillie à partir de l'intérieur du boîtier (15), laquelle diode est en contact électrique avec des surfaces de contact (28a, 28b) des pistes conductrices (18a, 18b) placées à l'intérieur du boîtier (15) à côté du percement (24) et **en ce que** la diode électroluminescente (17) est réalisée comme une diode électroluminescente SMD (SMD = Surface Mounted Device) qui comporte une puce de LED (35) et une tête de diode (32) transparente recouvrant cette dernière et qui est placée selon une orientation Upside -Down sur la face intérieure (25) de la paroi extérieure MID (23) de telle manière que sa tête de diode (32) transparente fait saillie dans le percement (24) fermé tout autour sur sa circonférence et que son socle de diode (33) plus large par rapport à celui-ci prend appui sur les surfaces de contact (28a, 28b) et est en contact électrique avec celles-ci, le socle de diode (33) étant enfoncé dans un creux (43) prévu dans la face intérieure (25) de la paroi extérieure MID (23) dont la largeur correspond sensiblement à celle du socle de diode (33).

2. Composant selon la revendication 1, **caractérisé en ce que** le socle de diode (33) est brasé avec les surfaces de contact associées (28a, 28b) pour établir le contact.

3. Composant selon la revendication 1 ou 2, **caractérisé en ce que** la tête de diode (32) se termine sans saillie par rapport à la face extérieure (26) de la paroi extérieure MID (23) à l'intérieur du percement (24).

4. Composant selon l'une des revendications 1 à 3, **caractérisé en ce que** le boîtier (8) dans son ensemble est un composant MID.

5. Composant selon l'une des revendications 1 à 4, **caractérisé en ce que** le boîtier (8) est réalisé en forme d'auget ou de cuvette avec une paroi de base (12) formée par la paroi extérieure MID (23) et avec une paroi latérale (14) circonférentielle faisant saillie à partir du bord de la paroi de base (12), l'espace intérieur du boîtier (15) défini par le boîtier (8) étant rempli d'une masse de scellement durcie (16).

6. Composant selon l'une des revendications 1 à 5, **caractérisé en ce qu'**il est prévu un entrefer annulaire (38) rempli d'une matière d'étanchéité (42) entre la tête de diode (32) et la paroi de percement (27) entourant cette dernière.

7. Composant selon la revendication 6, **caractérisé en ce que** l'entrefer annulaire (38) est un entrefer capillaire.

8. Composant selon la revendication 6 ou 7, **caractérisé en ce que** la matière d'étanchéité (42) est une matière qui présente une consistance liquide à l'état de mise en oeuvre et qui durcit ultérieurement.

9. Composant selon l'une des revendications 6 à 8, **caractérisé en ce que** la matière d'étanchéité (42) est une colle.

10. Composant selon l'une des revendications 6 à 9, **caractérisé en ce que**, dans la zone du pourtour extérieur de la diode électroluminescente (17), entre celle-ci et la paroi extérieure MID (23), il est prévu au moins un évidement de remplissage (45) se prolongeant par l'entrefer annulaire (38) et plus large que l'entrefer annulaire (38) qui est ouvert vers l'intérieur du boîtier (15) pour le remplissage de la matière d'étanchéité liquide (42) lors de l'assemblage du composant.

11. Composant selon la revendication 10, **caractérisé par** deux évidements de remplissage (45) sur des côtés opposés de la diode électroluminescente (17).

12. Composant selon la revendication 10 ou 11, **caractérisé en ce que** l'évidement de remplissage (45) est formé par un creux (47) de la paroi extérieure MID (23) recouvert latéralement au moins partiellement par la diode électroluminescente (17).
